# EUROPEAN PATENT SPECIFICATION

(11) **EP 4 572 052 B1**
(45) Date of publication and mention of the grant of the patent: **08.04.2026**
(21) Application number: 23215882.4
(22) Date of filing: 12.12.2023
(51) Int. Cl.: H02H 3/08, H02H 3/093, H02H 5/04, H02H 6/00, H02H 7/22, G01K 3/00

(54) **METHOD AND CIRCUIT FOR DETECTING AN EXCESS TEMPERATURE OF A CONDUCTOR**
VERFAHREN UND SCHALTUNGSANORDNUNG ZUR ERKENNUNG EINER ÜBERTEMPERATUR EINES LEITERS
PROCÉDÉ ET CIRCUIT DE DÉTECTION D'UNE TEMPÉRATURE EXCESSIVE D'UN CONDUCTEUR

(43) Date of publication of application: 18.06.2025
(73) Proprietor: STMicroelectronics International N.V., 1228 Plan-les-Ouates, Geneva (CH)
(72) Inventor: BARTHEL, Jochen, 83135 SCHECHEN (DE); LETOR, Romeo, 95030 MASCALUCIA (CT) (IT); RANDAZZO, Vincenzo, 95033 BIANCAVILLA (CT) (IT); CASTRO, Enrico, 95125 CATANIA (IT); TRECARICHI, Calogero Andrea, 93012 GELA (CL) (IT); MARZO, Alberto, 95014 GIARRE (CT) (IT)
(74) Representative: Cabinet Beaumont

(56) References cited:
- US-A1- 2020 266 623

## Description

### Technical field

The present disclosure relates generally to electronic circuits and more specifically to a method and circuit for detecting overheating in a conductor.

### Background art

As an electric current flows through a conductor, power dissipates according to the joule effect, which leads to an increase in temperature of the conductor. Power thermally radiated and conducted offsets some of the power dissipated by the joule effect. As a result, it is theoretically possible to estimate a current level that leads to an exact balance between heat production and dissipation. In theory, a conductor can withstand a direct current at this level or lower for an infinite time.

In practice, the current driven through a conductor can have an intensity that varies in time. For such cases, there is a technical problem in estimating quickly and precisely when there is a relatively high risk that the temperature will exceed the temperature limit.

In this respect, the technical solution disclosed in US 2020/266623 A1 is worth mentioning. It provides a circuit for controlling the temperature-over-time budget related to heat generation via the Joule effect in a conductor of an automotive wire harness. This circuit comprises a comparator, a logic circuit, a counter and a latch. The ratio of the measured current flowing through the conductor and a safety threshold is compared to different thresholds. A counter is incremented or decremented with a variable or fixed step size, respectively.

### Summary of Invention

According to one aspect, there is provided a method of detecting an excess temperature of a conductor, the method comprising: measuring the level of a current flowing through the conductor, wherein the current level is of a first value during a first time period and of a second value during a second time period, the first value being larger than a current limit and the second value being lower than the current limit;
- during the first period, estimating a first difference between the first value and the current limit, and incrementing a counter with a first step size selected as a function of the estimated first difference;
- during the second period, estimating a second difference between the second value and the current limit, and decrementing the counter with a second step size selected as a function of the estimated second difference; and
- generating an alert signal if a count value of the counter exceeds a count limit.

According to one embodiment, the first difference between the current level and the current limit is estimated by a first plurality of comparator, and the second difference between the current level and the current limit is estimated by a second plurality of comparators.

According to one embodiment, each of the comparators of the first and second plurality is configured to compare the current level with a corresponding threshold, the thresholds being fixed.

According to one embodiment, the first and second step sizes are generated by logic gates according to the estimated first and second differences.

According to one embodiment, during the second period, the counter is not decremented if its value is already at 0.

According to one embodiment, the level of the current flowing through the conductor is measured by a sensor at a fixed sampling rate.

According to one embodiment, the first step size has an exponential relationship with respect to the estimated first difference and the second step size has an exponential relationship with respect to the estimated second difference.

According to one embodiment, the alert signal is generated by a latch.

According to a further aspect, there is provided an electronic circuit configured to detect an excess temperature of a conductor, the circuit being configured to:
- measure the level of a current flowing through the conductor, wherein the current level is of a first value during a first time period and of a second value during a second time period, the first value being larger than a current limit and the second value being lower than the current limit;
- during the first period, estimate a first difference between the first value and the current limit, and increment a counter with a step size selected as a function of the estimated first difference;
- during the second period, estimate a second difference between the second value and the current limit, and decrement the counter with a step size selected as a function of the estimated second difference; and
- generate an alert signal if a count value of the counter exceeds a count limit.

According to one embodiment, the electronic circuit comprises a first plurality of comparators configured to estimate the first difference between the current level and the current limit, and a second plurality of comparators configured to estimate the second difference between the current level and the current limit.

According to one embodiment, the electronic circuit comprises:
- at least one analogic-to-digital converter configured to convert the first value of the current level into a first digital value and to convert the second value of the current level into a second digital value; and
- a processing device configured to execute instructions implementing:
   at least one first comparator for estimating the difference between the first digital value and the current limit;
   at least one second comparator for estimating the difference between the second digital value and the current limit; and the counter.

According to a further aspect, there is provided an electrical system comprising:
- a conductor through which an electrical current is flowing, wherein the current level is of a first value during a first time period and of a second value during a second time period, the first value being larger than a current limit and the second value being lower than the current limit ;
- a sensor configured to measure the current level over time; and
- the above-mentioned electronic circuit configured to detect an excess temperature of the conductor.

According to one embodiment, the electrical system further comprises a normalization circuit configured to normalize the measured levels of the current.

According to a further aspect, there is provided a vehicle comprising the above-mentioned system, wherein the conductor is an electric wire held in a wire harness.

### Brief description of drawings

The foregoing features and advantages, as well as others, will be described in detail in the following description of specific embodiments given by way of illustration and not limitation with reference to the accompanying drawings, in which:
Figure 1 schematically illustrates an electronic circuit configured to detect an excess temperature of a conductor according to an example embodiment of the present disclosure;
Figure 2 is a flow diagram illustrating a process for detecting an excess temperature of a conductor according to an example embodiment of the present disclosure;
Figure 3 schematically illustrates an electronic circuit for detecting an excess temperature of a conductor according to an example embodiment of the present disclosure;
Figure 4 shows two graphs illustrating an example of a current varying over time and the corresponding behavior of a counter and a latch of the electronic circuit of Figure 3;
Figure 5 is a graph illustrating an example of reference current values used by the electronic circuit of Figure 3;
Figure 6 is a graph illustrating an example of a set of reference current values used by the electronic circuit of Figure 3;
Figure 7 schematically illustrates an over-current detection system that incorporates the electronic circuit of Figure 3, according to an example embodiment of the present disclosure; and
Figures 8A to 8C are graphs illustrating examples of the certain parameters of the system of Figure 7 as a function of the input current intensity.

### Description of embodiments

Like features have been designated by like references in the various figures. In particular, the structural and/or functional features that are common among the various embodiments may have the same references and may dispose identical structural, dimensional and material properties.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10 %, and preferably within 5 %.

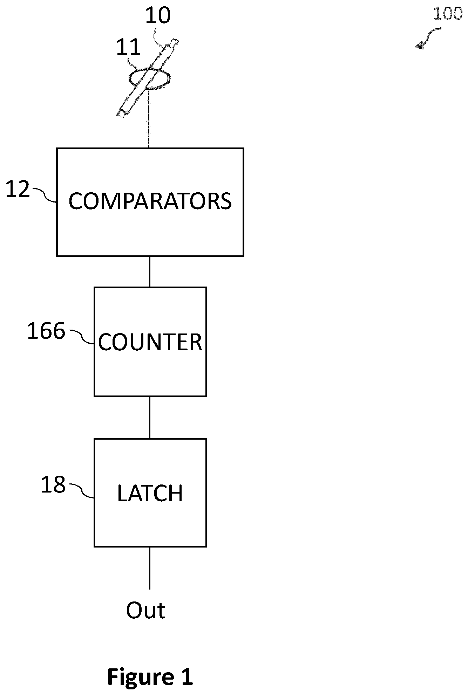

Figure 1 schematically illustrates an electronic circuit 100 configured to detect an excess temperature of a conductor according to an example embodiment of the present disclosure.

The electronic circuit 100 of Figure 1 for example comprises a conductor 10 through which an electric current propagates, a sensor 11 configured to measure the current, and to provide the current measurements to a detection circuit. The detection circuit ensures the conductor temperature does not exceed a temperature limit by controlling, for example, the root mean square of the current passing through the conductor. The detection circuit comprises, for example, a plurality of comparators 12 (COMPARATORS), a counter 166 (COUNTER) and a latch 18 (LATCH). The comparators 12 are for example configured to increment or decrement the counter 166 by step sizes determined based on the current measurements, such that the count value of the counter 166 approximates the behavior of the temperature of the conductor. The latch 18 is for example triggered when the count value exceeds a threshold count value, causing the latch 18 to generate an output signal (Out), indicating that the temperature of the conductor has exceeded a temperature limit associated with the threshold count value.

The conductor 10 depicted in Figure 1 can be regarded as exemplary of any electrical component configured to propagate a current. For example, in some embodiments, the conductor 10 is a wire held within a wire harness inside a vehicle. For example, the conductor 10 propagates a current that is used to drive a load, such as an electric motor, sound system, computing system, and/or any other electronic circuit. Besides, those skilled in the art will understand that the intensity of the electric current flowing through the conductor 10 may depend on the application of the electronic circuit, and on the state of the load that is driven by the current.

The intensity of the current flowing through the conductor 10 is for example measured by the sensor 11 and compared to a plurality of fixed reference values by the comparators 12. The sampling and comparisons are done for example using an analog value of the intensity that is for example converted to an electric voltage by the sensor 11. The current can be continuously sensed and fed through to the comparators or sampled at a fixed frequency, for example every 50ms, and stored in a capacitor during the time interval to be accessed by the comparators 12. A plurality of comparators is used to obtain an estimation of the sensed intensity with respect to a current limit labelled Inom, which is for example a nominal current limit. The relative difference between Inom and the sensed current intensity is for example used to set the step size for the counter 166. Depending on a current count value of the counter and the step size, the counter is either incremented or decremented as detailed hereafter.

If the count value at the output of the counter 166 exceeds a limit value, the latch 18 is for example triggered. For example, when the latch 18 is triggered, it generates and transmits an output signal Out, which is for example an alert signal that informs one or more further systems of the risk of overheating the conductor and/or a control signal causing the current through the conductor 10 to be reduced or stopped.

Although Figure 1 represents a hardware implementation, it will be apparent to those skilled in the art that functions of the elements 12, 166 and 18 could be implemented at least partially by software executed by an appropriate processing device (not illustrated). For example, in such a case, one or more analog-to-digital converters are used to convert analog samples of the measured current intensity into digital values and these digital values are processed in a similar manner to the processing performed by the comparators 12, counter 166 and latch 18 of Figure 1. The processing device for example outputs the output signal Out directly based on this software processing.

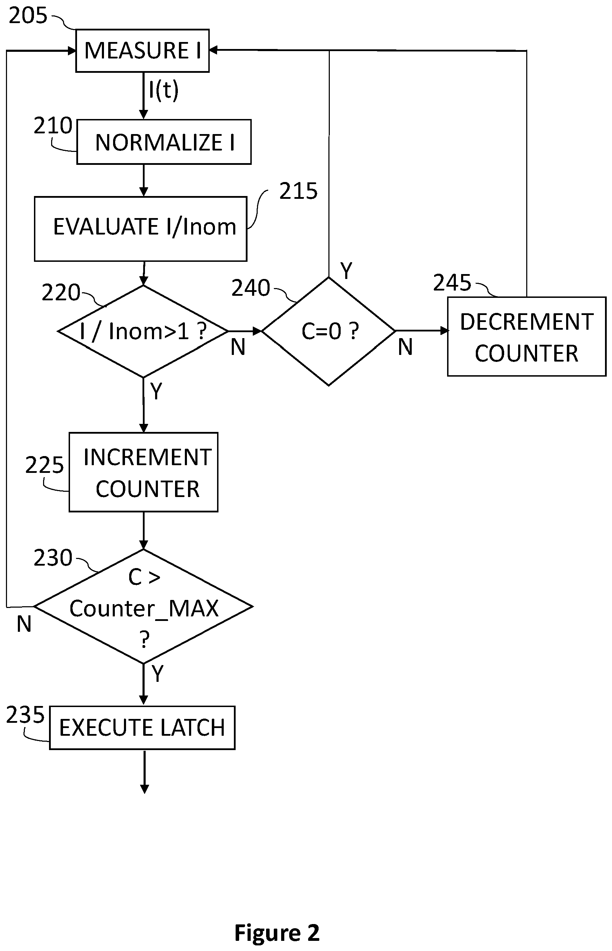

Figure 2 is a flow diagram illustrating a process for detecting an excess temperature of a conductor according to an example embodiment of the present disclosure.

The level of the current flowing through the conductor 10 is measured (block 205, "MEASURE I") by the sensor 11. For example, this operation is implemented by a periodic sampling operation, for example at a sampling frequency of between1kHz and 50kHz and for example of between 10kHz and 20kHz, such as equal to or around 16kHz.

In some embodiments, the measured current level is normalized with respect to the current limit, Inom (block 210, "NORMALIZE I"), for example by dividing the measured current by the current limit Inom. The nominal current limit is for example chosen during the design of the electronic circuit based on a characterization of the conductor. It corresponds for example to a value relatively close to the maximum current level that can flow through the conductor without elevating its temperature over time.

After the normalization of the current level 210, the normalized current level I/Inom is evaluated (block 215, "EVALUATE I/INOM"). For example, the evaluation of the normalized current level comprises using the comparators 12 to compare the normalized current I/Inom with a plurality of threshold values.

If the current flowing through the conductor 10 is larger than the nominal current limit (output Y of block 220, "I/Inom>1?"), there is a risk that the temperature of the conductor 10 becomes too high. The counter 166 is therefore incremented (block 225, "INCREMENT COUNTER") to take into account the elevated current. The step size of the increment is for example a function of the current level evaluated at the step 215.

If the incrementation of the counter 166 leads to the count value exceeding a count limit Counter_MAX (output Y of block 230, "C>Counter_MAX?"), it is for example considered that there is a risk that the current will cause damage to the conductor, and therefore the latch 18 is for example triggered (block 235, "EXECUTE LATCH"), causing it to generate the output signal Out.

If, after the incrementation of the counter during the step 225, the count value remains below Counter _MAX (output N of block 230), the temperature of the system is for example deemed safe for operation, and no action is taken. The method then for example returns to operation 205, and the level of the current through the conductor 10 is measured 205 again.

In the case that the normalized current evaluated in operation 215 is determined to be not larger than the nominal current limit (output N from the block 220), the temperature of the conductor 10 is considered to be decreasing over time. This is taken into account by adjusting the count value of the counter 166. If the count value is positive (output N of block 240, "C=0?"), the counter is decremented (block 245, "DECREMENT COUNTER"). The step size used to decrement the counter is a function of the current level evaluated at the step 215, and in particular as a function of a difference between the normalized current level and 1. After operation 245, the method for example returns to operation 205, during which the intensity of the current through the conductor 10 is measured 205 again.

If the current is lower than the nominal current limit and that the count value is already at zero (output Y of block 240, "C=0?"), the count value is left unchanged and the method for example returns to operation 205, during which the intensity of the current through the conductor 10 is measured 205 again.

While, in the example of Figure 2, the measured current level is normalized, in alternative embodiments, the current is not normalized. In such a case, operation 210 is omitted, and the current level measured by the sensor 11 is directly evaluated in operation 215 by comparison to the threshold values. Furthermore, in operation 220, rather than determining whether the normalized current level I/Inom is greater than 1, it is for example determined whether the measured current level I is greater than the current limit Inom.

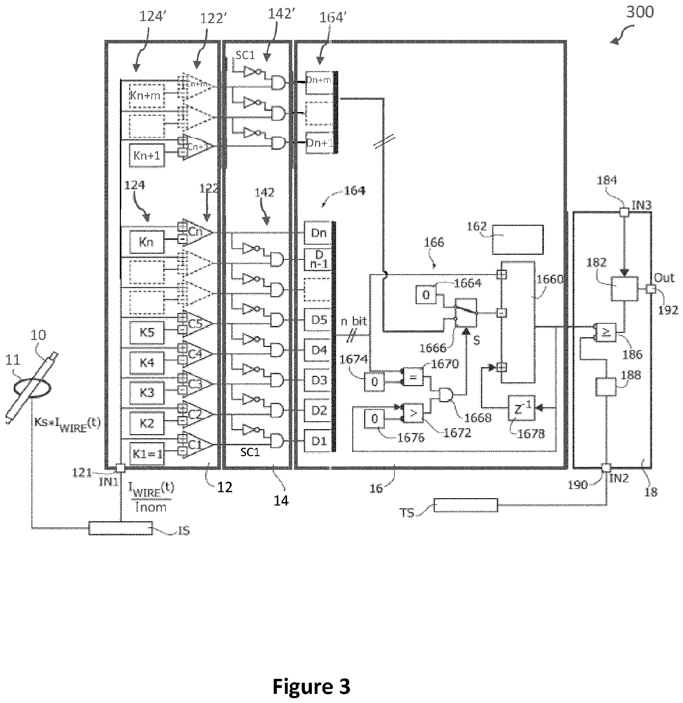

Figure 3 schematically illustrates an electronic circuit 300 for detecting an excess temperature of a conductor according to an example embodiment of the present disclosure. The circuit 300 for example provides an example hardware implementation of the electronic circuit 100 of Figure 1. It will be noted that the circuit 300 of Figure 3 has certain parts in common with Figure 1 of patent publication US202066623, and the contents of that patent publication is hereby incorporated by reference in its entirety to the extent permitted by the law.

According to the example embodiment of Figure 3, the circuit 300 comprises: the comparators 12; a logic circuit 14; a counter circuit 16 performing incrementations and decrementations of the counter 166; and the latch 18.

In some embodiments, the comparators 12, the logic circuit 14, the counter circuit 16 and the latch 18 are integrated within one or more integrated circuits. Alternatively, one or more components of these circuits 12, 14, 16 and 18 could be implemented as external elements. Similarly, in one or more embodiments, the circuit 300 may include further elements in addition to those exemplified herein.

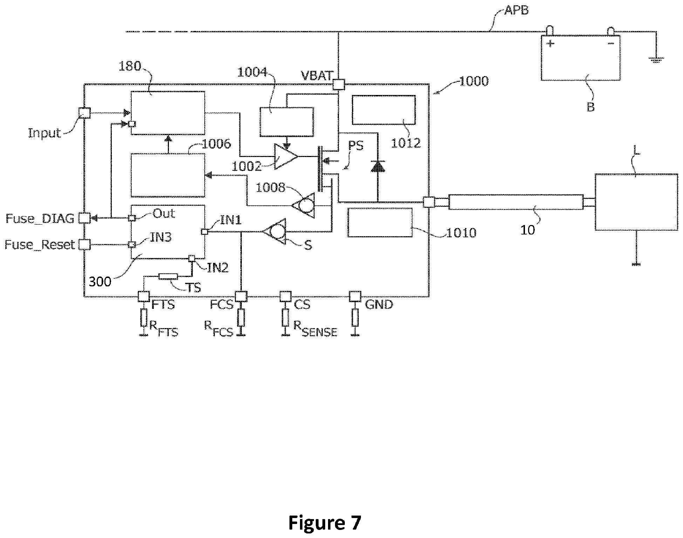

As exemplified herein, the comparators 12 for example comprise an input 121 configured to receive an input signal INl indicative of the current flowing through the conductor 10. The conductor 10 is for example associated with a load L (see Figure 7) and is intended to be protected against overheating, current overload and/or short circuit events, for instance.

In Figure 3, the sensor 11 is an amperometric sensor of any type configured to generate, during the operation 205 of Figure 2, a sensing signal Ks x I_{WIRE}(t) indicative of the level I_{WIPE}(t) of the current flowing through the conductor 10.

As exemplified in Figure 3, the sensor 11 is for example coupled to a setting circuit IS coupled between the sensor 11 and the input 121. The setting circuit IS is for example configured to generate, during the operation 210 of Figure 2, the normalized value of the current, namely I_{WIRE}(t)/Inom, which is applied to the input 121. In that way, the circuit 300 is for example configured to operate as a reversible fuse adapted to latch (that is interrupt or at least reduce) the current through the conductor 10 as a result of the current level being found to reach a safety threshold defined as a function of a setting parameter represented by Inom.

It will be appreciated that both the sensor 11 and the circuit IS for setting the nominal value Inom of the current may be distinct elements.

In one or more embodiments, the comparators 12 comprise a bank of comparators Cl, ..., Cn+m, collectively indicated as 122 for C1, ..., Cn and 122' for Cn+1, ..., Cn+m, configured to compare, during the operation 215 of Figure 2, the normalized current value I_{WIRE}(t)/Inom with respective comparison levels or thresholds Kl, ..., Kn+m, which are for example stored in respective registers in a bank of registers indicated collectively as 124 for K1, ..., Kn and 124' for Kn+1, ..., Kn+m.

For instance, the thresholds Kl, ..., Kn+m are set in such a way as to produce a correspondence between the number of thresholds and the number of bits associated with a bank of D registers 164 and 164'.

In one or more embodiments, the value of Kl is set by convention to unity (Kl= 1), by referring to the normalized current I_{WIRE}(t)/Inom.

For instance, the thresholds K2, ..., Kn 124 are larger than 1 and indicative of a period of temperature increase for the conductor 10, while Kn+1, ..., Kn+m 124' are smaller than 1 and indicative of a period of temperature decrease for the conductor.

Rather than being based on I_{WIRE}(t) /Inom, normalization may be carried out with reference to KlxI_{WIRE}(t)/Inom, where Kl is distinct from 1 and the n threshold values K1, ..., Kn are correspondingly set as (1xKl, K2xKl, KnxKl). This implementation is for example advantageous when the references are analog values, such as analog voltages, so that KnxKl can be set to a highest (maximum) value that is compatible with the highest analog value that can be fixed in the associated IC: for instance KnxKl<5 if the maximum allowed reference value is 5.

The logic circuit 14 for example comprises a combinatorial network comprising a plurality of stages collectively indicated as 142 and 142'. The stages 142 and 142' are for example configured to detect the respective outputs of the comparators Cl, C2, ..., Cn and Cn+1, ..., Cn+m respectively and identify the position of normalized current value I_{WIRE}(t) /Inom within the one-dimensional matrices [Kl, K2, ..., Kn] and [Kn+1, ..., Kn+m, K1] of the reference thresholds 124 and 124'. In operation, depending on the level of the normalized current value I_{WIRE}(t)/Inom, one of the outputs j of the logic circuit section 14 is for example set to a given value, such as logic_out(j)=l corresponding to Kj-1< I_{WIRE}(t)/Inom <Kj, with j designating the j-th reference threshold in the matrix [Kn+1, ..., Kn+m, Kl, K2, ..., Kn], while the other logic outputs are for example set to another value, for instance zero.

In the example of Figure 3, the stage 142 comprises n-1 AND gates, respectively having one of their inputs coupled to the output of a corresponding one of the comparators C1 to Cn-1, and their other inputs respectively coupled, via a corresponding NOT gate, to the outputs of the comparators C2 to Cn. The outputs of the n-1 AND gates, and of the comparator Cn, are respectively coupled to inputs of registers D1 to Dn of the counter circuit 16.

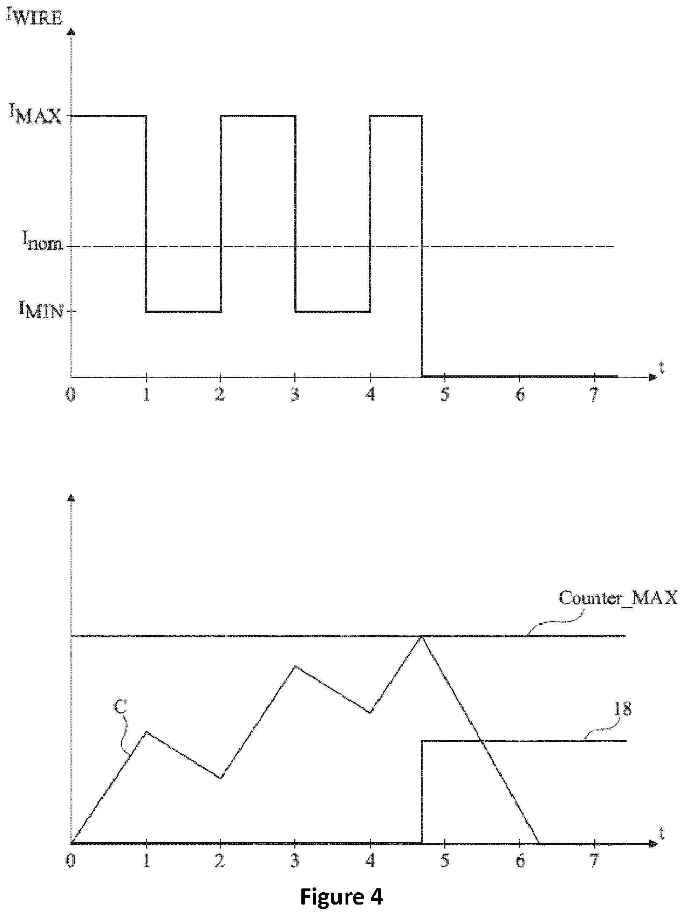

Furthermore, in the example of Figure 4, the stage 142' comprises m AND gates, respectively having one of their inputs coupled to the output of a corresponding one of the comparators Cn+1 to Cn+m, and their other inputs respectively coupled, via a corresponding NOT gate, to the outputs of the comparators Cn+1 to Cn+m. The outputs of the m AND gates are respectively coupled to inputs of registers Dn+1 to Dn+m of the counter circuit 16.

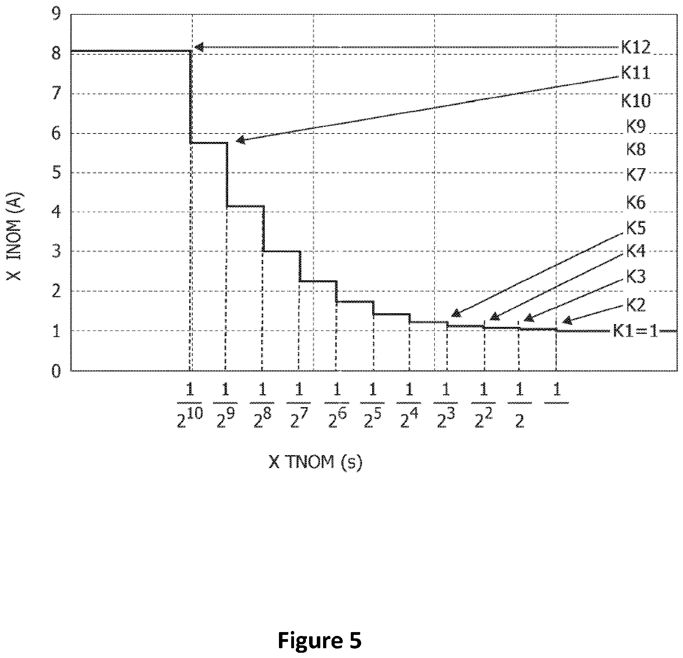

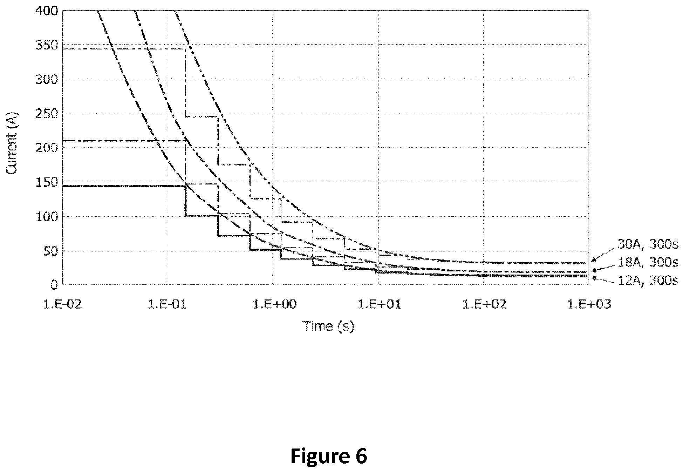

The thresholds applied by the comparators C1 to Cn and Cn+1 to Cm are for example fixed, but could also be variable in some embodiments. The thresholds are for example determined on the basis of criteria discussed below with reference to the Figures 5 and 6.

The counter circuit 16 operates at a fixed clock frequency provided by a clock generator 162, which may be part of the counter circuit 16 (as illustrated in the example of Figure 3) or could be provided by an external source. The counter circuit 16 for example comprises an input bank of flip-flops D, collectively indicated as 164 for D1 to Dn and 164' for Dn+1 to Dn+m, which are driven by respective outputs of the logic circuits 142 and 142' as mentioned above.

The outputs of the flip-flop banks 164 and 164' for example comprise one n-bit binary word and one m-bit binary word used to drive the counter 166.

The counter 166 is for example configured to perform a cumulative adder function via an adder circuit 1660 and a memory circuit (Z⁻¹) 1678 configured to store the current cumulative result. In particular, an input of the memory circuit 1678 is coupled to the output of the adder circuit 1660, and the output of the memory circuit 1678 is coupled to one input of the adder circuit 1660, which is configured to add the current cumulative result to an increment or decrement value provided by the flip-flop register banks 164 or 164'.

As exemplified herein, the counter 166 is driven either:
- to be incremented, for example during the operation 225 of Figure 2, by the n-bit word at the output of the flip-flop register bank 164 (at a "+" input at the top of the block 1660), and
- to be decremented, for example during the operation 245 of Figure 2, by the m-bit word at the output of the flip-flop register bank 164' or to maintain the current count value (output N of block 230 or Y of block 240 of Figure 2), corresponding to a zero-drop as exemplified by a block 1664 in Figure 3. This is for example set by the position of a switch 1666, which is configured to couple a negative count input "-" of the adder circuit 1660 to either the output of the register bank 164' or to the output of the zero-drop circuit block 1664.

The switch 1666 is for example controlled by an AND logic gate 1668, which for example has one of its inputs coupled to the output of an equality comparator 1670 and its other input coupled to the output of a "greater than" comparator 1672.

The equality comparator 1670 is for example configured to compare the n-bit word at the output of the flip-flop register bank 164 with a first zero reference block 1674, and to output a logic "1" if the n-bit word is equal to zero.

The "greater than" comparator 1672 is for example configured to compare the output of the adder circuit 1660 with an input from a second zero reference block 1676 and to output a logic "1" if the current cumulative count value is equal to zero.

Operation of the counter circuit 16 as exemplified in Figure 3 is essentially as follows. At a frequency set by the clock 162, the current flowing through the conductor 10 is sensed, normalized as a signal I_{WIRE}(t)/Inom, and its intensity is evaluated by the circuits 12 and 14, and the result is provided to the counter circuit 16 using the D registers.

If the signal I_{WIRE}(t)/Inom is higher than 1 (output Y of block 220 of Figure 2), the m-bit binary word in the register bank 164' is set to zero and the n-bit binary word in 164 has a value that is a function of the amount that the signal I_{WIRE}(t)/Inom is higher than 1. The counter 166 is incremented by the corresponding step size so that the increase in the count is indicative of how much the signal I_{WIRE}(t) is higher than Inom, and no decrement is applied since the output of the comparator 1670 is a logic "0".

If the signal I_{WIRE}(t)/Inom is smaller than 1 (output N of block 220 of Figure 2), the n-bit binary word in the register bank 164 is set to zero and the m-bit binary word in the register bank 164' has a value that is a function of the amount that the signal I_{WIRE}(t)/Inom is lower than 1. The counter 166 is not incremented since the n-bit word is at zero, and is decremented by the m-bit word if the count value is not already set to zero 1672, (output N of block 240 of Figure 2) so that the decrease in the count is indicative of how much the signal I_{WIRE}(t) is smaller than Inom. If the count of the counter 166 is already at zero (output Y of block 240 of Figure 2) the output from the counter 166 remains at zero, implying that there is a NOP (No OPeration).

Those skilled in the art will appreciate that "increment" and "decrement" as exemplified herein for the opposite counting directions for the counter 166 do not represent per se a mandatory choice insofar as one or more embodiments may adopt, mutatis mutandis, a complementary choice.

The latch circuit 18 as exemplified in Figure 3 includes a latch 182, which is for example reset via an input 184 (IN3) coupled to a control circuit (not illustrated) and which has its input coupled to the output of a comparator 186. The comparator 186 is for example configured to compare the output of the counter circuit 16, corresponding to the output of the adder circuit 1660, with a limit value, for instance an upper or maximum count value Counter_MAX, as provided by a limit generation circuit 188. The circuit 188 is for example coupled to an input 190 (labelled IN2) configured to receive a limit setting parameter Tnom from a setting circuit TS.

The value of Tnom is for example selectively set by the setting circuit TS at a nominal value corresponding to a desired response time of the latch circuit 18, which is for example configured to latch when a certain constant current (K2.Inom, by way of non-limiting example) is sensed to flow through the conductor 10. The circuit 300 may thus be configured to operate as a sort of adjustable slow-blow/ fastblow fuse whose time of intervention can be selectively adjusted.

It will be again appreciated that, as is the case for the circuit IS for setting the nominal value Inom for the current, the setting circuit TS for Tnom, may be a distinct circuit from the other circuits of the electronic circuit 300.

The setting circuit TS is for example implemented by appropriate circuitry, such as a lookup table or SPI (Serial Peripheral Interface) register or the like.

The latch circuit 18 as exemplified herein is for example configured to latch its output signal Out, at a node indicated as 192 in Figure 3, to a certain logic value (logic "1" for instance) as result of the value of the counter 166 reaching the limit value, equal to the upper value Counter _MAX set via the limit generation circuit 188, for instance, determined as a function of the setting signal Tnom received at the input 190.

In one or more embodiments, the value for the limit value Counter _MAX (an upper or maximum value will be considered herein for simplicity) is set by the limit generation circuit 188 based on the relationship: Counter _MAX= Tnom x clock_frequency, where clock_frequency designates the frequency of the clock 162 which, while represented as included in the circuit 16, may be configured to clock the operation of the whole circuit 300.

In this embodiment, there is no time constraint on the device when the current flowing through the conductor 10 is equal to Inom, which is a stable configuration. The parameter Tnom corresponds, for example, to the duration that a current with an intensity of K2 x Inom can flow through the conductor 10 while respecting the safety limits. For larger current intensities, evaluated by the comparators, the step size for the incrementation of the counter is adjusted accordingly.

A time matrix is for example defined that corresponds to the matrix for the "K" values in the comparator circuit 12 so that: Tnom x [∞ ,2°, 2¹, 2², ..., 2ⁿ⁻²], Inom(Kl, K2, K3, ..., Kn) where Tnom x 2^{I-2} may be held to correspond to the time to latch when a constant current Inom x KI is sensed to flow through the conductor 10.

The notation above takes into account the shift in the K indexes, with Kl becoming K2 and so on. Also the nominal time is held to correspond to the first step. After the shift, the first step is K2 and the value 1=Kl is for example associated to T=∞.

The elements in such a matrix can be regarded as defining a reaction time versus current curve, which can be approximated by N steps as discussed below in connection with Figures 5 and 6.

Figure 3 illustrates a hardware implementation of an embodiment of the present disclosure. It will be apparent to those skilled in the art that a software implementation could be used, based in particular on a set of instructions executed by a processing device, such as a CPU (central processing unit). For example, in such a case, one or more analog-to-digital converters are used to convert analog samples of the measured current intensity into digital values. For example, interleaved analog-to-digital converters are used to achieve a relatively high processing speed. The digital values are processed in a similar manner to the processing performed by the circuits 12, 14, 16 and 18 of Figure 3. The processing device for example outputs the output signal Out directly based on this software processing.

Figure 4 shows two graphs illustrating an example of a current varying over time and the corresponding behavior of the counter 166 and the latch 18 of the electronic circuit of Figure 3.

The top graph of Figure 4 shows one example of a pulsed current I_{WIRE} between two current levels I_{MIN} and I_{MAX} in the conductor 10 over a period of time, I_{MIN} being lower than Inom and I_{MAX} being higher than Inom.

During the same period of time, the count value C is shown in the bottom graph of Figure 4. During the periods when I_{WIRE}=I_{MAX}, the count value increases and during the periods when I_{WIRE}=I_{MIN}, the count value decreases. The rate of variation of the count value is thus representative of the current levels during the periods of both incrementation and decrementation.

When the count value reaches the threshold value Counter_MAX, the latch 18 is triggered. In the example of Figure 4, this causes the current flow through the conductor 10 to be interrupted, and thus the current level drops to zero, and the count value C also drops progressively to zero. It will be noted that the rate of decrementation of the counter following the triggering of the latch is larger than the rate of decrementation during the periods of the current level I_{MIN}, because the zero current level is lower than I_{MIN}.

Figure 5 is a graph illustrating an example of reference current values used by the electronic circuit 300 of Figure 3.

The graph of Figure 5 is exemplary of the possibility of intervening on the "time axis"/"current axis" matrix namely Tnom x [∞ ,2°, 2¹, 2², ..., 2ⁿ⁻²], Inom(Kl, K2, K3, ..., Kn) in order to generate a notionally infinite number of current/time (IT) curves by setting the two parameters Inom (circuit IS and input 121 in Figure 3) and Tnom (input circuit TS and input 190 in Figure 3). The current and time values in an IT curve may define a current amplitude and a pulse duration, which for example leads the temperature of the conductor to reach a specified limit (maximum) temperature.

By acting on the value of the thresholds KI (which may be assumed to be identical for simplicity, but may even be selected to be different to pursue an even finer matching), such an IT curve can be fitted with the characteristics of the conductor 10 to be protected (e.g. a wiring harness). Such characteristics are currently found to exhibit a sort of hyperbole-like behavior (as exemplified in Figure 6), which lends itself to be fitted to a 1/2^{I} (I=0, 1, 2, ...) behavior of the relationship linking Inom and Tnom in a circuit such as the circuit 300 of Figure 3.

Likewise, for current intensities lower than Inom, example threshold values are for example set according to Table 1 hereafter:

**[Table 1]**

| K value | Current interval |
|---|---|
| -1 | [0.75*Inom : Inom [ |
| -4 | [0.50*Inom : 0.75*Inom [ |
| -8 | [0.25*Inom : 0.50*Inom [ |
| -16 | [0 : 0.25*Inom [ |

Figure 6 is a graph illustrating an example of a set of reference current values used by the electronic circuit of Figure 3.

The IT response of a circuit such as the circuit 300 is for example fitted to a desired behavior by setting a value for Inom with reference to a highest (maximum) DC current.

By way of example, the graph of Figure 6 refers to three possible DC currents: 12A (dashed line), 18A (chain line), and 30A (double dotted chain line).

These values may correspond, for instance, to wire section areas corresponding to 0.5mm², 1.0mm² and 2.5mm².

For instance, the IT curves of Figure 6 may be rated at a maximum wire temperature of 150° C, and an ambient temperature of 85° C maximum, so that the value for Inom may be caused to correspond to a highest acceptable current root mean square (rms) value I_{RMS} with all the IT values of the circuit 300 adapted to be automatically fitted to the wire IT curve and the time of intervention of the latch circuit 18 correspondingly adjusted, by setting Tnom, to be gradually reduced as the value of the current decreases (from right to left in the diagram of Figure 6) to increasingly higher values with respect to the "asymptotic" value possibly related to long times, such as 300s.

Of course, the indicated value of 300s as the time corresponding to the first step is merely by way of example. That value can change in a manner coordinated with the values used to decrement the counter 166 when I_{WIRE} is below Inom. If the values for the decrementation are changed, fitting will still be possible by setting a different time value.

Figure 7 schematically illustrates an over-current detection system that incorporates the electronic circuit of Figure 3, according to an example embodiment of the present disclosure.

Figure 7 is exemplary of the possible use of a circuit 300 as exemplified in Figure 3 within the framework of a system 1000, which facilitates the protection of a conductor 10 supplying a load L.

As exemplified in Figure 7, such a system may include a "smart" power switch and a power supply source, such as an Automotive Power Bus APB, coupled to the positive pole B+ of a battery B at a voltage VBAT.

In one or more embodiments, a system 1000 as exemplified in Figure 7 may include a power switch PS such as, for instance, a power MOSFET transistor having the current path therethrough (source-drain in the case of a field-effect transistor such as a MOSFET transistor) coupling the power supply VBAT with the conductor 10 and the control terminal of the power transistors PS (gate, in the case of field-effect transistor such as a MOSFET transistor) driven via a logic circuit 180, which is sensitive to a drive signal of the load L as received at a drive node indicated as Input as well the output signal Out at the node 192 of the latch section of the circuit 300.

In Figure 7, parts or elements like parts or elements already discussed in connection with the previous figures are indicated by like references: a detailed description of these parts or elements will not be repeated.

The control electrode (gate, for instance) of the power transistor PS is for example controlled by the circuit 180 via a control stage 1002 coupled to a VDS clamp circuit 1004, which is in turn sensitive to the battery voltage VBAT with the ensuing possibility of disconnecting the conductor 10 in the presence of an over-voltage condition over the voltage VBAT.

The embodiment of Figure 7 also highlights the possibility for the circuit 180 to be sensitive to the output of a silicon protection circuit 1006, which is in turn sensitive, via a current sensing circuit 1008, to the current through the power transistor PS and thus through the conductor 10.

The same current can be sensed by the sensor 11 configured to be coupled to the input 121 (INl) of the circuit of Figure 3.

The embodiment of Figure 7, which also refers to the possible presence of a charge pump 1010, illustrates that, in addition to being provided to the circuit 180 in order to reduce/interrupt the current through the conductor 10, the output signal Out from the latch 18 of the circuit 300 is also for example provided to an output pin Fuse_DIAG, which may be used for diagnostic purposes, e.g. by being set high when the "fuse" 300 is in latched state.

In Figure 7, Fuse _Reset denotes an input pin available for fuse control, which can be connected to the input node IN3 (node 184 Figure 3) as a reset pin for the latch.

In Figure 7, an input pin designated FTS is shown being coupled via a resistor of resistance R_{FTS} to ground GND with the purpose of setting the value of Tnom, so that the TS circuit of Figure 3 may contribute to calculating the value of the count limit Counter _MAX as a function of the resistance R_{FTS}.

In Figure 7, a pin designated FCS is also shown coupled to ground via a resistor of resistance R_{FCS}, which may be used to set the value of Inom (see the circuit IS in Figure 3).

For instance, in one or more embodiments, the circuit IS is implemented as a current generator that generates a current Ks*I_{WIRE}(t) proportional to the current I_{WIRE}(t) in the conductor 10. This may occur, for instance, via a sensfet feature associated with the transistor PS. The resistance R_{FCS} between the pin FCS and ground may be used to set the value for Inom so that, for instance, the voltage at the input node 121 in Figure 3 (that is, INl) is substantially equal to 1 when I_{WIRE} equals Inom.

The embodiment of Figure 7 also refers to the possible presence of further pins designated CS (a function that may be provided in "smart" power devices) and GND (the ground of the IC of the system 1000).

Figure 7 is exemplary of one possible, non-limiting application of certain embodiments to a control circuit embedded in an otherwise conventional "smart" power IC. There are of course many other possible applications that may benefit from the capability of controlling the temperature-over-time budget of a conductor having a current flowing therethrough.

A circuit 300 as exemplified herein may thus be included (embedded, for instance) is a system having a different configuration from the one exemplified in Figure 7. For instance, a circuit 300 as exemplified herein may be embedded in a gate driver not including a power switch.

In one or more embodiments, the operating parameters are for set in a manner different from the manner presented herein by way of example. For instance, the parameters Inom and/or Tnom can be set via a serial bus. Furthermore, as an alternative to the analog implementation exemplified in Figure 7, the circuits IS and TS can be implemented as digital circuits.

Likewise, sensing the current I_{WIRE}(t) may be via a shunt amperometric arrangement.

Analog-to-digital (AID) conversion of the current I_{WIRE}(t) may facilitate current management in an entirely digital manner.

The circuit 300 as exemplified herein may be used either to interact with a driver to interrupt a current, such as when I_{RMS}>Inom, in order to limit the current flowing in a wire by PWM (Pulse-Width Modulation) or just to issue a warning.

As noted, a circuit 300 as exemplified herein is able to measure the I_{RMS} value insofar as the parameters (thresholds) K2 to Kn can be selected as normalized values of a current defined for normalized values of the timing (1 to 2n-2).

The values K2 to Kn may be fixed values such that, if multiplied by Inom, they define an IT curve fitting with the wire IT characteristics, where the wire IT characteristics are defined for a maximum temperature of the wires with a given ambient temperature, which is facilitated by the fact that K2 to Kn can be calculated for a constant value of I_{RMS}.

One or more embodiments as exemplified herein facilitate the I_{RMS} calculation/evaluation by implementing the calculation of the integral of I²(t) over time (that is *∫* I²(t)dt) as a simple counter where the incremental value dt is discrete and made variable as a function of the current.

One or more embodiments take advantage of using power of 2 (2^{j}) incremental values as this facilitates a simple implementation of the counter. Determining (calculating) the current thresholds as Inom x (Kl, ..., Kn) facilitates obtaining a counting result which is representative of I_{RMS}.

One or more embodiments were found to operate correctly also when the current I(t) is variable with fast transients insofar as a system clock frequency can be selected which is (much) higher (ten time higher, for instance) than the frequency bandwidth of I(t). In that way, the incremental value (2^{j}) is updated many times during a transient. This facilitates achieving a high degree of precision as a function of the resolution of the references Inom x (Kl, ... Kn).

One or more embodiments as exemplified herein also consider the parameters (thresholds) Kn+1 to Kn+m to evaluate the current intensity when it is below Inom to improve the accuracy of the evaluation of the temperature of the conductor 10, in particular during periods of time when it is cooling down.

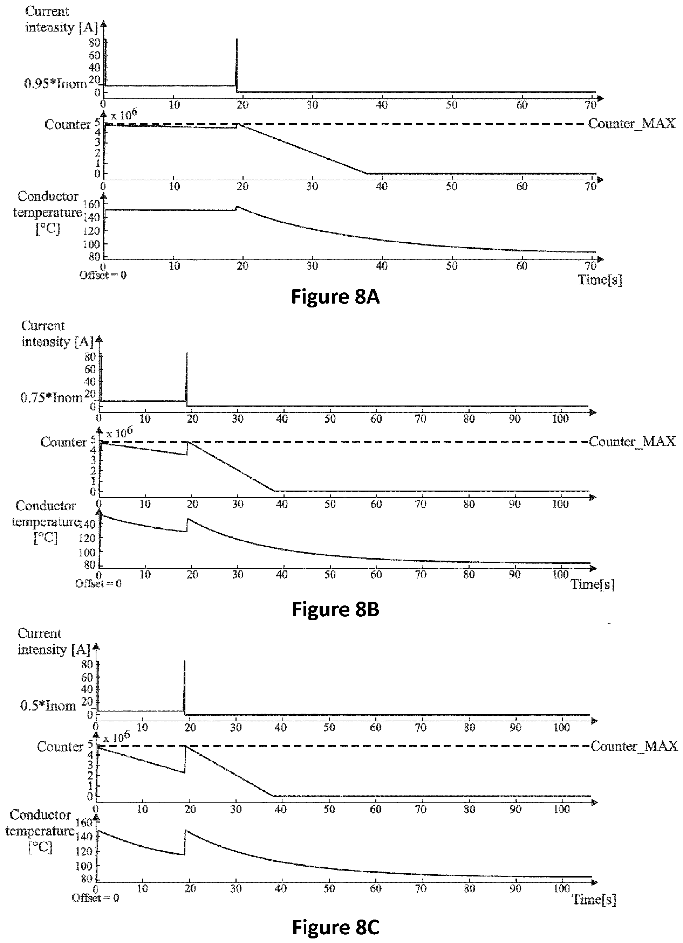

Figures 8A to 8C are graphs illustrating examples of the certain parameters of the system of Figure 7 as a function of the input current intensity.

The graphs of Figures 8A, 8B and 8C each illustrate, in three corresponding sub-graphs, the current level (Current intensity [A]) through the conductor, the count value (Counter), and the temperature of the conductor (Conductor temperature [°C]), again time (Time[s]).

In Figures 8A, 8B and 8C, the nominal current Inom is set to the example level of 10A. The plot shows two bursts of current separated by a period of time during which the current intensity is 0.95xInom, 0.75xInom and 0.5xInom respectively for the Figures 8A to 8C.

The counter is incremented with a relatively large step size during the first burst, but remains below the threshold Counter_MAX. It then decays at a different rate for the three figures 8A, 8B and 8C in accordance with the three current levels.

The second burst of current leads to the count value reaching Count_MAX, which triggers the latch 18. The current intensity drops to zero and the count value C decays faster until reaching zero as well.

In all three figures 8A, 8B and 8C, the temperature of the conductor follows the behavior of the counter and remains below 155°C, the maximum authorized temperature in these examples.

An advantage of the embodiments described herein in which a counter is not only incremented, but also decremented as a function of the current level through a conductor, is that they permit a quick and precise estimation of when a temperature limit of the conductor risks being exceeded.

Furthermore, improving the estimation of the temperature of the conductor allows certain parameters of the circuit to be more finely tuned, such as for example the cross-section diameter of the conductor that is used. This can allow in particular the use of thinner conductors for a same load, which results is reduced weight and consumption of the circuit comprising the conductors and the associated load.

Various embodiments and variants have been described. Those skilled in the art will understand that certain features of these embodiments can be combined and other variants will readily occur to those skilled in the art. For example, it will be apparent to those skilled in the art that, rather than being based on an analog implementation, a fully digital implementation of the comparator circuit 12 would be possible.

Finally, the practical implementation of the embodiments and variants described herein is within the capabilities of those skilled in the art based on the functional description provided hereinabove.

## Claims

1. A method of detecting an excess temperature of a conductor (10), the method comprising:
- measuring the level of a current flowing through the conductor (10), wherein the current level is of a first value during a first time period and of a second value during a second time period, the first value being larger than a current limit (Inom) and the second value being lower than the current limit;
- during the first period, estimating a first difference between the first value and the current limit, and incrementing a counter (166) with a first step size selected as a function of the estimated first difference;
- during the second period, estimating a second difference between the second value and the current limit, and decrementing the counter with a second step size selected as a function of the estimated second difference; and
- generating an alert signal (Out) if a count value of the counter exceeds a count limit (Counter_MAX).

2. The method according to claim 1, wherein the first difference between the current level and the current limit is estimated by a first plurality of comparators (122), and the second difference between the current level and the current limit is estimated by a second plurality of comparators (122').

3. The method according to claim 2, wherein each of the comparators (12) of the first and second plurality is configured to compare the current level with a corresponding threshold, the thresholds being fixed.

4. The method according to any one of claims 1 to 3, wherein the first and second step sizes are generated by logic gates (14) according to the estimated first and second differences.

5. The method according to any one of claims 1 to 4, wherein, during the second period, the counter (166) is not decremented if its value is already at 0.

6. The method according to any one of claims 1 to 5, wherein the level of the current flowing through the conductor is measured by a sensor (11) at a fixed sampling rate.

7. The method according to any one of claims 1 to 6, wherein the first step size has an exponential relationship with respect to the estimated first difference and the second step size has an exponential relationship with respect to the estimated second difference.

8. The method according to any one of claims 1 to 7, wherein the alert signal (Out) is generated by a latch (18).

9. An electronic circuit (300) configured to detect an excess temperature of a conductor (10), the circuit being configured to:
- measure the level of a current flowing through the conductor, wherein the current level is of a first value during a first time period and of a second value during a second time period, the first value being larger than a current limit (Inom) and the second value being lower than the current limit;
- during the first period, estimate a first difference between the first value and the current limit, and increment a counter (166) with a step size selected as a function of the estimated first difference;
- during the second period, estimate a second difference between the second value and the current limit, and decrement the counter with a step size selected as a function of the estimated second difference; and
- generate an alert signal (Out) if a count value of the counter exceeds a count limit (Counter _MAX).

10. The electronic circuit of claim 9, comprising a first plurality of comparators (122) configured to estimate the first difference between the current level and the current limit, and a second plurality of comparators (122') configured to estimate the second difference between the current level and the current limit.

11. The electronic circuit of claim 9, comprising:
- at least one analogic-to-digital converter configured to convert the first value of the current level into a first digital value and to convert the second value of the current level into a second digital value; and
- a processing device configured to execute instructions implementing:
at least one first comparator for estimating the difference between the first digital value and the current limit;
at least one second comparator for estimating the difference between the second digital value and the current limit; and
the counter.

12. An electrical system comprising:
- a conductor (10) through which an electrical current is flowing, wherein the current level is of a first value during a first time period and of a second value during a second time period, the first value being larger than a current limit (Inom) and the second value being lower than the current limit ;
- a sensor (11) configured to measure the current level over time; and
- the electronic circuit of any of the claims 9 to 11 configured to detect an excess temperature of the conductor.

13. The electrical system according to claim 12, further comprising a normalization circuit (IS) configured to normalize the measured levels of the current.

14. A vehicle comprising the system of claim 12 or 13, wherein the conductor (10) is an electric wire held in a wire harness.

## Patentansprüche

1. Ein Verfahren zum Detektieren einer Übertemperatur eines Leiters (10), wobei das Verfahren Folgendes aufweist:
- Messen des Pegels eines Stroms, der durch den Leiter (10) fließt, wobei der Strompegel während eines ersten Zeitraums einen ersten Wert und während eines zweiten Zeitraums einen zweiten Wert hat, wobei der erste Wert größer als ein Stromgrenzwert (Inom) ist und der zweite Wert kleiner als der Stromgrenzwert ist;
- während des ersten Zeitraums Schätzen einer ersten Differenz zwischen dem ersten Wert und dem Stromgrenzwert und Inkrementieren eines Zählers (166) mit einer ersten Schrittweite, die als Funktion der geschätzten ersten Differenz ausgewählt wird;
- während des zweiten Zeitraums, Schätzen einer zweiten Differenz zwischen dem zweiten Wert und dem Stromgrenzwert und Verringern des Zählers mit einer zweiten Schrittweite, die als Funktion der geschätzten zweiten Differenz ausgewählt wird; und
- Erzeugen eines Alarmsignals (Out), wenn ein Zählwert des Zählers einen Zählgrenzwert (Counter_MAX) überschreitet.

2. Das Verfahren nach Anspruch 1, wobei die erste Differenz zwischen dem Strompegel und dem Stromgrenzwert durch eine erste Vielzahl von Komparatoren (122) geschätzt wird und die zweite Differenz zwischen dem Strompegel und dem Stromgrenzwert durch eine zweite Vielzahl von Komparatoren (122') geschätzt wird.

3. Das Verfahren nach Anspruch 2, wobei jeder der Komparatoren (12) der ersten und zweiten Vielzahl konfiguriert ist zum Vergleichen des Strompegels mit einem entsprechenden Schwellenwert, wobei die Schwellenwerte fest sind.

4. Das Verfahren nach einem der Ansprüche 1 bis 3, wobei die erste und zweite Schrittweite durch Logikgatter (14) nach den geschätzten ersten und zweiten Differenzen erzeugt werden.

5. Das Verfahren nach einem der Ansprüche 1 bis 4, wobei während dem zweiten Zeitraum der Zähler (166) nicht verringert wird, wenn sein Wert bereits bei 0 liegt.

6. Das Verfahren nach einem der Ansprüche 1 bis 5, wobei der Pegel des Stroms, der durch den Leiter fließt, durch einen Sensor (11) mit einer festen Abtastrate gemessen wird.

7. Das Verfahren nach einem der Ansprüche 1 bis 6, wobei die erste Schrittweite eine exponentielle Beziehung in Bezug auf die geschätzte erste Differenz hat und die zweite Schrittweite eine exponentielle Beziehung in Bezug auf die geschätzte zweite Differenz hat.

8. Das Verfahren nach einem der Ansprüche 1 bis 7, wobei das Alarmsignal (Out) durch einen Latch (18) erzeugt wird.

9. Eine elektronische Schaltung (300), die konfiguriert ist zum Detektieren einer Übertemperatur eines Leiters (10), wobei die Schaltung konfiguriert ist zum:
- Messen des Pegels eines Stroms, der durch den Leiter fließt, wobei der Strompegel während eines ersten Zeitraums einen ersten Wert und während eines zweiten Zeitraums einen zweiten Wert hat, wobei der erste Wert größer als ein Stromgrenzwert (Inom) ist und der zweite Wert kleiner als der Stromgrenzwert ist;
- während des ersten Zeitraums Schätzen einer ersten Differenz zwischen dem ersten Wert und dem Stromgrenzwert und Inkrementieren eines Zählers (166) mit einer Schrittweite, die als Funktion der geschätzten ersten Differenz ausgewählt wird;
- während des zweiten Zeitraums, Schätzen einer zweiten Differenz zwischen dem zweiten Wert und dem Stromgrenzwert und Verringern des Zählers mit einer Schrittweite, die als Funktion der geschätzten zweiten Differenz ausgewählt wird; und
- Erzeugen eines Alarmsignals (Out), wenn ein Zählwert des Zählers einen Zählgrenzwert (Counter_MAX) überschreitet.

10. Die Elektronische Schaltung nach Anspruch 9, aufweisend eine erste Vielzahl von Komparatoren (122), die konfiguriert sind zum Schätzen der ersten Differenz zwischen dem Strompegel und dem Stromgrenzwert, und eine zweite Vielzahl von Komparatoren (122'), die konfiguriert sind zum Schätzen der zweiten Differenz zwischen dem Strompegel und dem Stromgrenzwert.

11. Die Elektronische Schaltung nach Anspruch 9, aufweisend:
- wenigstens einen Analog-Digital-Wandler, der konfiguriert ist zum Wandeln des ersten Werts des Strompegels in einen ersten digitalen Wert und zum Wandeln des zweiten Werts des Strompegels in einen zweiten digitalen Wert; und
- eine Verarbeitungseinrichtung, die konfiguriert ist zum Ausführen von Anweisungen, die Folgendes implementieren:
wenigstens einen ersten Komparator zum Schätzen der Differenz zwischen dem ersten digitalen Wert und dem Stromgrenzwert;
wenigstens einen zweiten Komparator zum Schätzen der Differenz zwischen dem zweiten digitalen Wert und dem Stromgrenzwert; und
den Zähler.

12. Ein Elektrisches System, das Folgendes aufweist:
- einen Leiter (10), durch den ein elektrischer Strom fließt, wobei der Strompegel einen ersten Wert während eines ersten Zeitraums und einen zweiten Wert während eines zweiten Zeitraums hat, wobei der erste Wert größer als ein Stromgrenzwert (Inom) ist und der zweite Wert niedriger als der Stromgrenzwert ist;
- einen Sensor (11), der konfiguriert ist zum Messen des Strompegels über die Zeit; und
- die elektronische Schaltung nach einem der Ansprüche 9 bis 11, die konfiguriert ist zum Detektieren einer Übertemperatur des Leiters.

13. Das Elektrisches System nach Anspruch 12, ferner aufweisend eine Normalisierungs-Schaltung (IS), die konfiguriert ist zum Normalisieren der gemessenen Pegel des Stroms.

14. Ein Fahrzeug, das das System nach Anspruch 12 oder 13 aufweist, wobei der Leiter (10) ein elektrischer Draht ist, der in einem Kabelbaum gehalten wird.

## Revendications

1. Procédé de détection d'une température excessive d'un conducteur (10), le procédé comprenant :
- la mesure du niveau d'un courant circulant dans le conducteur (10), dans lequel le niveau du courant est d'une première valeur pendant une première période de temps et d'une deuxième valeur pendant une deuxième période de temps, la première valeur étant supérieure à une limite de courant (Inom) et la deuxième valeur étant inférieure à la limite de courant ;
- pendant la première période, l'estimation d'une première différence entre la première valeur et la limite de courant, et l'incrémentation d'un compteur (166) avec une première taille de pas d'incrémentation sélectionnée en fonction de la première différence estimée ;
- pendant la deuxième période, l'estimation d'une deuxième différence entre la deuxième valeur et la limite de courant, et la décrémentation du compteur avec une deuxième taille de pas d'incrémentation sélectionnée en fonction de la deuxième différence estimée ; et
- la génération d'un signal d'alerte (Out) si la valeur de comptage du compteur dépasse une limite de comptage (Counter _MAX).

2. Procédé selon la revendication 1, dans lequel la première différence entre le niveau de courant et la limite de courant est estimée par une première pluralité de comparateurs (122), et la deuxième différence entre le niveau de courant et la limite de courant est estimée par une deuxième pluralité de comparateurs (122').

3. Procédé selon la revendication 2, dans lequel chacun des comparateurs (12) de la première et de la deuxième pluralité est configuré pour comparer le niveau de courant avec un seuil correspondant, les seuils étant fixes.

4. Procédé selon l'une quelconque des revendications 1 à 3, dans lequel les première et deuxième tailles de pas d'incrémentation sont générées par des portes logiques (14) selon les première et deuxième différences estimées.

5. Procédé selon l'une quelconque des revendications 1 à 4, dans lequel, pendant la deuxième période, le compteur (166) n'est pas décrémenté si sa valeur est déjà à 0.

6. Procédé selon l'une quelconque des revendications 1 à 5, dans lequel le niveau du courant circulant dans le conducteur est mesuré par un capteur (11) à une fréquence d'échantillonnage fixe.

7. Procédé selon l'une quelconque des revendications 1 à 6, dans lequel la taille du premier pas d'incrémentation a une relation exponentielle par rapport à la première différence estimée et la taille du deuxième pas d'incrémentation a une relation exponentielle par rapport à la deuxième différence estimée.

8. Procédé selon l'une quelconque des revendications 1 à 7, dans lequel le signal d'alerte (Out) est généré par une bascule (18).

9. Circuit électronique (300) configuré pour détecter une température excessive d'un conducteur (10), le circuit étant configuré pour :
- mesurer le niveau d'un courant circulant dans le conducteur, dans lequel le niveau du courant est d'une première valeur pendant une première période de temps et d'une deuxième valeur pendant une deuxième période de temps, la première valeur étant supérieure à une limite de courant (Inom) et la deuxième valeur étant inférieure à la limite de courant ;
- pendant la première période, estimer une première différence entre la première valeur et la limite de courant, et incrémenter un compteur (166) avec une première taille de pas d'incrémentation sélectionnée en fonction de la première différence estimée ;
- pendant la deuxième période, estimer une deuxième différence entre la deuxième valeur et la limite de courant, et décrémenter le compteur avec une deuxième taille de pas d'incrémentation sélectionnée en fonction de la deuxième différence estimée ; et
- générer un signal d'alerte (Out) si une valeur de comptage du compteur dépasse une limite de comptage (Counter _MAX).

10. Circuit électronique selon la revendication 9, comprenant une première pluralité de comparateurs (122) configurée pour estimer la première différence entre le niveau de courant et la limite de courant, et une deuxième pluralité de comparateurs (122') configurée pour estimer la deuxième différence entre le niveau de courant et la limite de courant.

11. Circuit électronique selon la revendication 9, comprenant :
- au moins un convertisseur analogique-numérique configuré pour convertir la première valeur du niveau de courant en une première valeur numérique et pour convertir la deuxième valeur du niveau de courant en une deuxième valeur numérique ; et
- un dispositif de traitement configuré pour exécuter des instructions mettant en œuvre :
au moins un premier comparateur pour estimer la différence entre la première valeur numérique et la limite de courant ;
au moins un deuxième comparateur pour estimer la différence entre la deuxième valeur numérique et la limite de courant ; et
le compteur.

12. Système électrique comprenant :
- un conducteur (10) à travers lequel circule un courant électrique, dans lequel le niveau de courant est d'une première valeur pendant une première période de temps et d'une deuxième valeur pendant une deuxième période de temps, la première valeur étant supérieure à une limite de courant (Inom) et la deuxième valeur étant inférieure à la limite de courant ;
- un capteur (11) configuré pour mesurer le niveau de courant au cours du temps ; et
- le circuit électronique selon l'une quelconque des revendications 9 à 11 configuré pour détecter une température excessive du conducteur.

13. Système électrique selon la revendication 12, comprenant en outre un circuit de normalisation (IS) configuré pour normaliser les niveaux mesurés du courant.

14. Véhicule comprenant le système selon la revendication 12 ou 13, dans lequel le conducteur (10) est un câble électrique maintenu dans un faisceau de câbles.
